# EUROPEAN PATENT SPECIFICATION

(11) **EP 4 205 827 B1**
(45) Date of publication and mention of the grant of the patent: **03.09.2025**
(21) Application number: 21861998.9
(22) Date of filing: 23.08.2021
(51) Int. Cl.: A63H 33/04, A63H 33/22, A63H 5/00, A63H 33/08, H01R 13/10, H04B 1/38, H04B 3/54, H01R 107/00, H01R 31/06

(54) **ELECTRONIC ASSEMBLY BLOCK**
ELEKTRONISCHER MONTAGEBLOCK
BLOC D'ASSEMBLAGE ÉLECTRONIQUE

(30) Priority: 25.08.2020 KR 20200106935
(43) Date of publication of application: 05.07.2023
(73) Proprietor: 130T Inc., Seoul 06787 (KR)
(72) Inventor: CHO, Young Jik, Seoul 07914 (KR)
(74) Representative: Cabinet Beaumont
(86) International application number: PCT/KR2021/011208
(87) International publication number: WO 2022/045701

(56) References cited:
- EP-A1- 3 669 957
- CN-A- 102 114 352
- CN-U- 208 356 114
- KR-A- 20200 025 465
- KR-A- 20200 025 465
- KR-B1- 101 483 017
- KR-B1- 101 483 017
- US-A1- 2014 327 312
- US-A1- 2014 327 312
- US-A1- 2019 192 985
- US-A1- 2019 192 985

## Description

### Technical Field

The present disclosure relates to electronic assembly blocks and, more particularly, to electronic assembly blocks capable of constructing various intelligent toy robot models by stacking and combining electronic assembly blocks more conveniently and stably using power line communication.

### Background Art

Lego is a world-famous toy manufacturer, and its self-invented building toys may develop children's intelligence and exercise children's hands-on skills. Currently, there are many toys assembled in the Lego style on the market, and most of the toys are stacked with blocks of different sizes to create toy models with different themes.

Traditional assembly-block toys do not have the function of interacting with users, so traditional assembly-type building-block toys quickly become boring and make children gradually lose interest.

Accordingly, along with the development of electronic technology, some of the large domestic toy manufacturers have introduced modular electronic robot kits, but such robots are basically connected to various modules with built-in electronic devices through connection wires and external wires. Accordingly, when there are many wires and interfaces, there are problems in that it is easy to confuse users, making it difficult to construct a model, and children's misoperation damages the interfaces, resulting in poor contact between connection terminals.

In addition, the magnetic force assembling type light-emitting block device disclosed in conventional Korean Patent No. 0946794 includes unit blocks each provided in a hexahedron shape so as to be able to be mutually stacked in order to allow interconnections and electrical connections to be made by magnetic force, and a power supply configured to be able to supply power to the unit blocks. In this case, the unit block is provided with a light-emitting diode that is mounted at the inside thereof and configured to emit light to the outside by the supplied power and a plurality of relay magnetic electrodes wired with the light-emitting diode by being provided to be exposed on the surface of the unit blocks so that power may be supplied to the light-emitting diode but provided with a magnetic material having conductivity. In addition, the power supply is provided with a main body provided on an upper surface with a plurality of main magnetic electrodes that is provided with a magnetic material having conductivity so that electrical contact may be made with the relay magnetic electrode by magnetic force so as to correspond to a relay magnetic electrode formation pattern of the unit block, so that the power supplied from the power source may be supplied to the unit block. According to such a magnetic force assembling type light-emitting block device, the unit blocks are mutually assembled and also electrically connected, by magnetic force, to emit light, so interest in block assembly may be further enhanced when used for toys, and an advantage is provided in that various types of light-emitting decorations may be easy to assemble.

However, in the above invention, a connection method using a magnetic substance affects a circuit of the function of the electronic device by magnetic force, causing malfunction, and in particular, there are constraints that children or infants are required to match the magnetic electrodes when assembling blocks, so there is a problem with implementing various types of assembly models.

Document US2019192985A1 discloses an electronic building-block module that includes a main body, multiple projections spacedly arranged on a top surface of the main body, a circuit board, multiple main connectors and multiple sub connectors; the electronic building-block module has multiple recesses which are provided at a bottom portion of the main body for respectively accommodating the multiple projections; the main body has a cavity therein, the circuit board is located within the cavity; each of the multiple projections has a cylindrical shape with an upper opening, the multiple main connectors are respectively located within the upper opening of the multiple projections; the multiple sub connectors are respectively located within a lower opening of the multiple recesses; the multiple main connectors of one electronic building-block module are respectively in nested connection with the multiple sub connectors of another electronic building-block module.

### Disclosure

### Technical Problem

Accordingly, the present disclosure has been made keeping in mind the above problems occurring in the related art. The present disclosure is to provide electronic assembly blocks that may be used for building various intelligent toy robot models, the blocks being stacked and combined more conveniently and stably using power line communication.

In addition, the present disclosure is to provide electronic assembly blocks that may be used with assembly blocks such as existing Lego blocks and may be used for building a toy robot model with flexible user-toy interaction by being interconnected and communicated through control blocks and input/output blocks.

### Technical Solution

In order to accomplish the above objectives, there may be provided an electronic assembly block according to an embodiment of the present disclosure, the block including: a first circuit board provided with a first connector disposed thereon, the first connector including a cylindrical power data terminal and a cylindrical ground terminal disposed to be spaced apart from and at an outer side of the power data terminal; a second circuit board provided with a second connector disposed thereon, the second connector having a cylindrical protrusion and including a power data piece 71 provided on an inner surface of the protrusion and a ground piece provided on an outer surface of the protrusion; a connection part electrically connecting the first circuit board and the second circuit board; a housing having the first circuit board and the second circuit board disposed in a hollow thereof and providing an outer shell; and a sub-housing coupled with the housing and having a through-hole provided at a part corresponding to the second connector to allow the second connector to be exposed when coupled with the housing.

In addition, the connection part may include: a connection socket disposed on a surface opposite to a surface provided with a first connector disposed thereon of the first circuit board and having one end configured to come in contact with an electrical contact and an opposite end provided with an opening configured to receive a pin; and a connection pin disposed on a surface opposite to a surface provided with a second connector disposed thereon of the second circuit board and having one end configured to come in contact with an electrical contact and an opposite end provided with the pin configured to be correspondingly coupled with the opening.

Furthermore, when at least two electronic building blocks are combined with each other, a cylindrical power data terminal of the first connector and a power data piece provided on an inner surface of the protrusion of the second connector are brought into contact with each other, and a cylindrical ground terminal of the first connector and a ground piece provided on an outer surface of the protrusion of the second connector are brought into contact with each other, so that the electronic building blocks combined with each other may be electrically connected, thereby allowing data to be transmitted and received by power line communication.

In addition, the block may further include: a control block configured to perform data communication by transmitting and receiving control signals to and from blocks assembled thereto; an input block configured to transmit an input signal detected from the outside to the control block; and an output block configured to output data according to a request signal received from the control block.

The control block may be connected in series or parallel to the input block and the output block to perform data communication.

The control block, the input block, and the output block each may include: a PLC module configured to supply or receive power and to transmit and receive data, through a PLC line; and a control module configured to transmit and receive a control signal with the PLC module.

The control block may include: a communication block configured to wirelessly perform data communication with the blocks assembled thereto through a wireless communication module; and a power block configured to supply power to the blocks assembled thereto through a power storage unit.

The input block may include at least any one of:
a sensor module composed of a sensor configured to detect and operate at an inner side of the housing; a sound module composed of a sound sensor configured to detect sound at an inner side the housing and change volume of the sound into an analog value; a filming module composed of a camera configured to film an image; and a switch module provided with a switch configured to be able to receive a state of being pressed-unpressed input thereto by being provided on an outer side of the housing.

The sensor module may include at least any one of a Gyro sensor, a Color sensor, an Infrared (IR) sensor, an Ultrasonic sensor, a Laser (distance) sensor, and a Light sensor.

The output block may include at least any one of a driving block, a light-emitting block, and a melody block.

The control block may be configured to perform a block scan operation for checking whether the input block and the output block are connected thereto.

When a power switch is turned on, the control block may be configured to perform an operation of reading initialization data from the power block to perform a data initialization process.

When an output value of the output block needs to be changed, the control block may be configured to perform an operation of requesting the output block to change the output value.

### Advantageous Effects

Electronic assembly blocks according to the present disclosure as described above can be used for building various intelligent toy robot models by being stacked and combined more conveniently and stably using power line communication.

In addition, the electronic assembly blocks can be used with assembly blocks such as existing Lego blocks, and a toy robot model with flexible user-toy interaction can be built by interconnecting and communicating through control blocks and input/output blocks.

### Description of Drawings

FIG. 1 is a perspective view showing an electronic assembly block according to an embodiment of the present disclosure.
FIG. 2 shows exploded perspective views showing the electronic assembly block according to the embodiment of the present disclosure.
FIG. 3 shows exploded side views showing by seeing through the electronic assembly block according to the embodiment of the present disclosure.
FIG. 4 is a bottom view showing a bottom surface of the electronic assembly block according to the embodiment of the present disclosure.
FIG. 5 is a sectional view showing a cross section taken along line A-A' in FIG. 1.
FIG. 6 is a sectional view showing a state in which electronic assembly blocks are coupled according to the embodiment of the present disclosure.
FIG. 7 is a circuit diagram briefly explaining power line communication of the electronic assembly block according to the embodiment of the present disclosure.
FIG. 8 is a block diagram briefly showing a configuration of power and data transmission by assembling the electronic assembly blocks according to the embodiment of the present disclosure.
FIG. 9 is a flowchart explaining a data initialization process between a communication block and a power block of a control block according to the embodiment of the present disclosure.
FIG. 10 is a flowchart explaining a process of checking a connection between a control block and input/output blocks according to the embodiment of the present disclosure.
FIG. 11 is a flowchart explaining an operation between a control block and an input block according to the embodiment of the present disclosure.
FIG. 12 is a flowchart explaining an operation between a control block and an output block according to the embodiment of the present disclosure.
FIGS. 13A and 13B are use state diagrams showing an embodiment of a toy robot model assembled with electronic assembly blocks according to the present disclosure.

### Mode for Invention

Hereinafter, exemplary embodiments of the present disclosure will be described in detail with reference to the accompanying drawings in order to clarify the technical spirit of the present disclosure. In describing the present disclosure, when it is determined that a detailed description of a related known function or component may unnecessarily obfuscate the subject matter of the present disclosure, the detailed description will be omitted. Elements having substantially the same functional configuration in the drawings are assigned the same reference numerals and symbols as much as possible, even though they are displayed on different drawings. For the convenience of description, the device and method are described together when necessary.

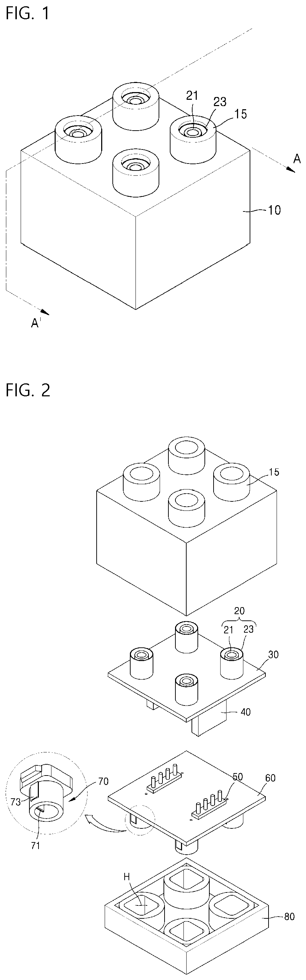

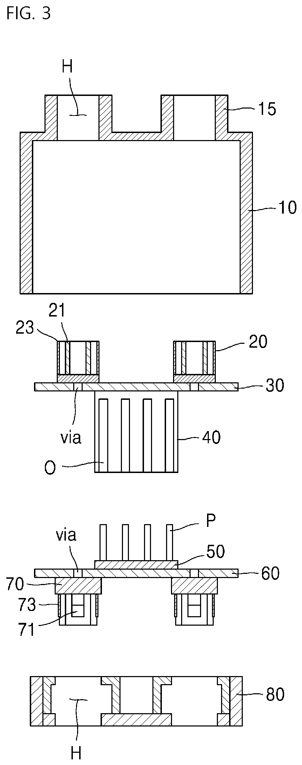

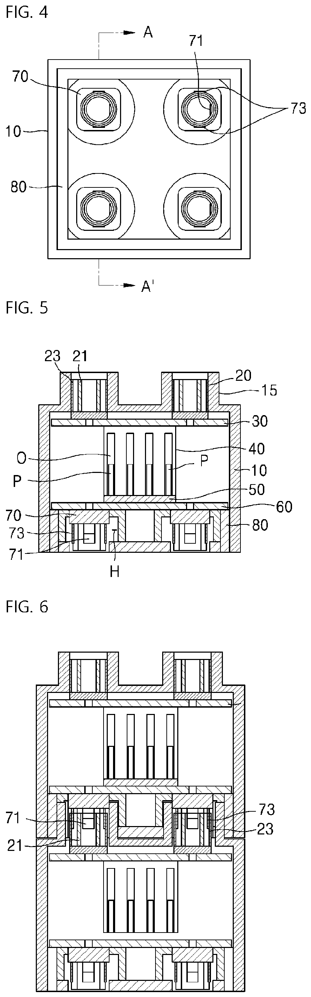

FIG. 1 is a perspective view showing an electronic assembly block according to an embodiment of the present disclosure, FIG. 2 shows exploded perspective views showing the electronic assembly block according to the embodiment of the present disclosure, FIG. 3 shows exploded side views showing by seeing through the electronic assembly block according to the embodiment of the present disclosure, FIG. 4 is a bottom view showing a bottom surface of the electronic assembly block according to the embodiment of the present disclosure, and FIG. 5 is a sectional view showing a cross section taken along line A-A' in FIG. 1.

The electronic assembly block of the present disclosure may make various intelligent toy robot models by stacking and combining electronic assembly blocks more conveniently and stably using power line communication. Here, Power Line Communication (PLC) is a communication method that transmits and receives data using a power line, and a system may be configured in various ways by combining functional modules such as Central Processing Unit (CPU), communication, specialness, and input/output modules.

With reference to FIGS. 1 to 5, the electronic assembly block may include a housing 10, a protrusion 15 provided on an upper surface of the housing 10, and a sub-housing 80 that is coupled to a lower portion of the housing 10 and provided with a sub-hole H provided to correspond to the protrusion 15. The housing 10 may place circuit boards 30 and 60 in a hollow thereof and provide an outer shell preventing the hollow from being exposed to the outside.

The protrusion 15 may be provided with a through hole H exposed to the outside. The protrusion 15 may be composed of one or more protrusions 15 depending on a shape of the electronic assembly block for coupling between the blocks. In the embodiment, a housing 10 having a square shape provided with four protrusions 15 may be implemented. Furthermore, depending on the embodiment, the housing may be implemented in various shapes provided according to the designer's design such as a right-angled quadrangular housing with 2, 6, 8, 12, and 16 protrusions, a trapezoidal housing with two protrusions, and the like. In addition, the housing 10 may be implemented in a shape compatible with assembly blocks such as existing Lego blocks.

The circuit boards 30 and 60 may include a first circuit board 30 and a second circuit board 60.

The first circuit board 30 is provided with a first connector 20 disposed thereon and may transmit and receive electrical signals. The first circuit board 30 may bond the first connector 20 through soldering.

The first connector 20 is disposed inside the protrusion 15 and may be exposed to the outside through an upper opening. The first connector 20 may include a cylindrical power data terminal 21 and a cylindrical ground terminal 23 that is disposed to be spaced apart from and disposed at an outer side of the power data terminal. In the first connector 20, the power data terminal 21 and the ground terminal 23 may be made of a conductive material such as metal. The first connector 20 may transmit and receive power and data through the power data terminal 21 and may transmit and receive the power and data with the power line communication. The first connector 20 may be connected to the ground through a ground terminal 23.

The second circuit board 60 is provided with the second connector 70 thereunder and may transmit and receive electrical signals. The second circuit board 60 may bond the second connector 70 through soldering.

The second connector 70 may be exposed to the outside through the through hole H provided in the sub-housing 80. The second connector 70 is provided with a protrusion having a cylindrical shape, wherein the power data piece 71 may be provided on an inner surface of the protrusion and a ground piece 73 may be provided on an outer surface of the protrusion. The second connector 70 may be made of an insulating material such as plastic material, and the power data piece 71 and the ground piece 73 may be made of a conductive material such as metal material. The second connector 70 may transmit and receive power and data through the power data piece 71 and may transmit and receive the power and data with the power line communication. The second connector 70 may be connected to the ground through a ground piece 73.

The first circuit board 30 and the second circuit board 60 may be electrically connected through a connection part.

The connection part may include a connection socket 40 and a connection pin 50.

The connection socket 40 is disposed on a surface opposite to a surface provided with a first connector disposed thereon of the first circuit board 30 and may have: one end configured to come in contact with an electrical contact point through a via hole of the first circuit board 30; and an opposite end provided with an opening O configured to receive a pin P.

The connection pin 50 is disposed on a surface opposite to a surface provided with a second connector 70 disposed thereon of the second circuit board 60 and may have: one end configured to come in contact with an electrical contact through a via hole of the second circuit board 60; and an opposite end provided with the pin configured to be correspondingly coupled with the opening O.

The first circuit board 30 and the second circuit board 60 may be mounted with a control module, a memory, a programmable controller, an analog converter, an input/output module, and other electronic components.

FIG. 6 is a sectional view showing a state in which electronic assembly blocks are coupled according to the embodiment of the present disclosure.

With reference to FIG. 6, it represents a state in which at least two electronic building blocks are combined with each other. At this time, the first connector 20 and the second connector 70 may be coupled to be connected. Here, coupling may mean fitted coupling. The cylindrical power data terminal 21 of the first connector 20 and the power data piece 71 provided on the inner surface of the protrusion of the second connector 70 come into contact with each other to be electrically connected so that power and data may be transmitted and received. In addition, the cylindrical ground terminal 23 of the first connector 20 and the ground piece 73 provided on the outer surface of the protrusion of the second connector 70 come into contact with each other to be electrically connected so that grounding may be established.

As a result, the electronic assembly blocks may create various intelligent toy robot models by stacking and combining the electronic assembly blocks more conveniently and stably using the power line communication, so there are advantages of being intoxicated by visually and aurally stimulating interest and a sense of achievement in children.

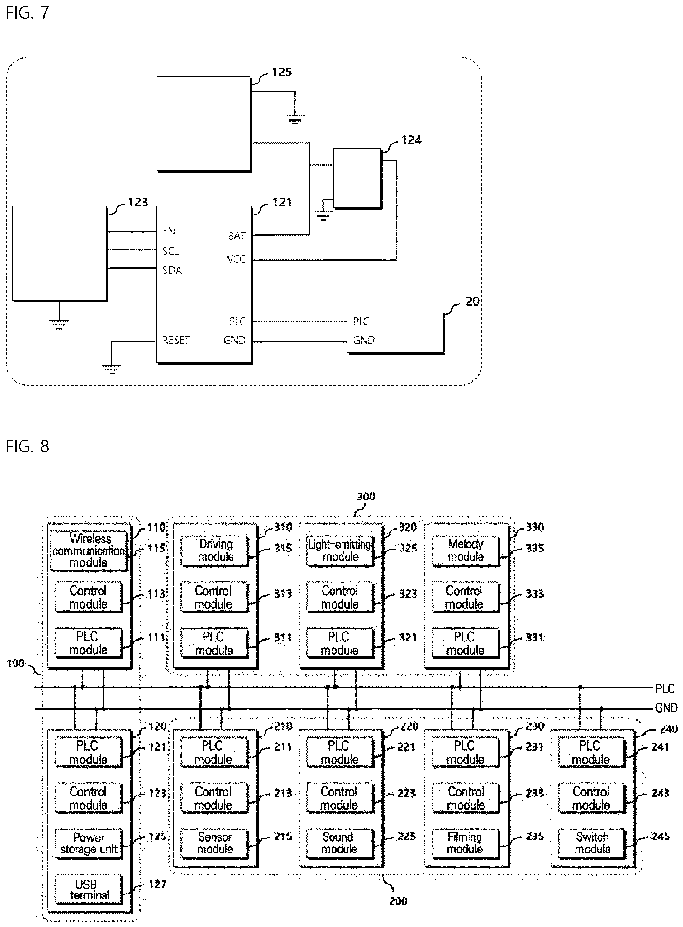

FIG. 7 is a circuit diagram briefly explaining power line communication of the electronic assembly block according to the embodiment of the present disclosure.

With reference to FIGS. 1 and 7, the electronic assembly block may perform power line communication through the configuration of the first connector 20, a PLC module 121, and a control module 123. The communication speed between the electronic assembly blocks of the present disclosure may operate at 166,700 bps, and the communication speed between the electronic assembly blocks and external electronic devices may operate at a speed of 115,200 bps or more. In the present embodiment, the electronic assembly block will be described by taking a power block 120 as an example.

The power data terminal 21 and the ground terminal 23 of the first connector 20 are terminals for supplying power and transmitting and receiving data. The power data terminal 21 may be connected to the PLC module 121 through a PLC line to supply power or transmit and receive data. The ground terminal 23 may be connected to the PLC module 121 through the GND line to be grounded.

The power storage unit 125 is composed of a battery or its own power supply module and may supply power to the inside of the electronic assembly block. At this time, the power storage unit 125 may supply power by converting the output current through a converter 124. In addition, the power storage unit 125 may supply power so as to be able to operate even during being charged.

The PLC module 121 is configured to receive power from the power storage unit 125 through the power line VCC and to supply power by being connected to the control module 123. In addition, when a plurality of electronic assembly blocks is connected, the PLC module 121 may supply or receive power in parallel through each PLC line.

When a plurality of electronic assembly blocks is connected, the PLC module 121 may transmit and receive data through each PLC line. Accordingly, the PLC module 121 may transmit and receive a Serial CLock (SCL) signal of a clock signal and a Serial DAta (SDA) signal of data to and from the control module 123. At this time, the PLC module 121 may transmit data to the control module 123 through the SDA line in line with the SCL signal of the clock signal.

In addition, the PLC module 121 may transmit and receive control signals to and from the control module 123 through an ENable (EN) line. The control signal of the control module 123 means a signal configured to control the electronic assembly block to transmit its own command or identification information by activating the assembled electronic assembly block. The control module 123 may transmit a control signal, then wait for data reception from the PCL line, and receive a command or identification information of the assembled electronic assembly block. That is, the control module 123 may transmit a control signal requesting data and receive a response signal according to the request.

Meanwhile, the PLC module 121 may include a Reset for initializing a controller function in addition to a power line VCC for receiving power. In addition, the power line VCC may supply power and simultaneously give a signal to the Reset, thereby initializing the electronic assembly block as a whole. The PLC module 121 is initialized when an input signal is received through the power line VCC or Reset, and the program recorded in the memory may be executed from the beginning.

FIG. 8 is a block diagram briefly showing a configuration of power and data transmission by assembling the electronic assembly blocks according to the embodiment of the present disclosure.

With reference to FIGS. 7 and 8, the electronic assembly block may include a control block 100, an input block 200, and an output block 300.

The control block 100 is an electronic assembly block that may be combined in a prefabricated manner and may be assembled with the input block 200 and the output block 300. The control block 100 may be connected in series or parallel to the input block 200 and the output block 300 to perform data communication.

When assembled and connected, the control block 100 and the input/output blocks 200 and 300 may perform data communication while transmitting and receiving control signals. At this time, the connected electronic assembly blocks may transmit and receive data through power line communication and may supply or receive power.

The control block 100 may perform a block scan operation for checking whether the input/output blocks 200 and 300 are connected thereto. The control block 100 may perform at a preset cycle an operation of requesting an input value, with respect to the connected input block 200. Here, the preset period may be performed in seconds (sec) units/minute (min) units.

In addition, when an output value of the output block 300 needs to be changed, the control block 100 may perform an operation of requesting the output value.

The control block 100 may include a communication block 110 and a power block 120.

The communication block 110 may serve as a host of the electronic assembly blocks. In the embodiment, the communication block 110 may perform a role as a main host and, at the same time, the power block 120 may perform a role as a sub-host.

The communication block 110 may include a PLC module 111, a control module 113, and a wireless communication module 115. The PLC module 111 and the control module 113 are the same as those described in FIG. 7, so the description thereof will be omitted.

The wireless communication module 115 may perform data communication wirelessly by connecting to the assembled electronic assembly blocks. The wireless communication module 115 may perform data communication wirelessly by connecting to a smart terminal (not shown). The wireless communication module 115 is configured to receive an operation signal from the smart terminal to transfer the output signal to the output block 300 and return data received from the input block 200 to the smart terminal.

The wireless communication module 115 may be configured with wireless communication means or short-range wireless communication means, such as Bluetooth, Wi-Fi, infrared communication, RF communication, and the like.

The smart terminal may be configured with a terminal having a computer function and a display function, such as a smartphone, a tablet PC, a PDA, a personal computer, a laptop computer, and the like. The smart terminal may execute programming by installing a program. The smart terminal may transmit the programmed data to the electronic assembly block to check the execution result through the electronic assembly block.

The power block 120 may include a PLC module 121, a control module 123, and a power storage unit 125. Depending on the embodiment, the power block 120 may further include a USB terminal 127 for charging the power storage unit 125. The power block 120 may control the start and end of an operation for an electronic assembly block. In addition, the power block 120 may store various data transmitted between electronic assembly blocks in non-volatile memory.

The power storage unit 125 is composed of a battery or its own power supply module and may supply power to the inside of the electronic assembly block. In addition, the power storage unit 125 may supply power so as to be able to operate even during being charged.

The PLC module 121 is configured to receive power from the power storage unit 125 through the power line VCC and to supply power by being connected to the control module 123. In addition, when a plurality of electronic assembly blocks is connected, the PLC module 121 may supply or receive power in parallel through each PLC line.

When the plurality of electronic assembly blocks is connected, the PLC module 121 may transmit and receive data through each PLC line. In addition, the PLC module 121 may transmit and receive control signals to and from the control module 123. The control signal of the control module 123 means a signal configured to control the electronic assembly block to transmit its own command or identification information by activating the assembled electronic assembly block.

The control module 123 may transmit a control signal, then wait for data reception from the PCL line, and receive a command or identification information of the assembled electronic assembly block. That is, the control module 123 may transmit a control signal requesting data and receive a response signal according to the request.

The input block 200 may include a sensor block 210, a sound block 220, a filming block 230, and a switch block 240. The input blocks 210, 220, 230, and 240, respectively, include PLC modules 211, 221, 231, and 241 and control modules 213, 223, 233, and 243, and the description thereof is the same as that of FIG. 7 and thus omitted. The input block 200 may transmit an input signal detected from the outside to the control block 100.

The sensor block 210 may include a PLC module 211, a control module 213, and a sensor module 215. The sensor module 215 may be composed of various sensors that detect and operate at an inner side of the housing 10.

The sensor module 215 may be implemented by including at least one of a Gyro sensor, a Color sensor, an Infrared (IR) sensor, an Ultrasonic sensor, a Laser (distance) sensor, and a Light sensor.

The sensor module 215 including the Gyro sensor may measure the motion and angle of the electronic assembly block by measuring accelerations in x, y, and z axes. For example, the sensor module 215 including the Gyro sensor may be used to make an electronic assembly block robot that does not fall.

The sensor module 215 including a color sensor may measure the color of a target object. The sensor module 215 including the color sensor may be used when specifying the movement of the electronic assembly block by measuring the color of an object that is in front of the corresponding sensor module 215 (measurement surface). For example, the electronic assembly block robot in which the sensor module 215 including the color sensor is assembled may perform an operation to move backward when encountering a red wall and an operation to turn right when encountering a blue wall.

The sensor module 215 including an infrared sensor may detect an object at a short distance (0.1 cm to 10 cm). The sensor module 215 including an infrared sensor may be used to make an electronic assembly block robot that does not collide with objects. For example, an electronic assembly block robot in which the sensor module 215 including an infrared sensor is assembled may distinguish between white and black detected values, and thus perform an operation of following a black line.

The sensor module 215 including the ultrasonic sensor may detect an object at a long distance (2 cm to 40 cm). The sensor module 215 including the ultrasonic sensor may be used when an electronic assembly block robot that does not collide with an object is made or when an electronic assembly block robot that follows an object is made.

The sensor module 215 including the laser sensor may accurately measure a long distance (2 cm to 40 cm) regardless of surrounding disturbances (sun, fluorescent light, darkness). The sensor module 215 including the laser sensor may be used when a tape measure robot that measures a distance is made.

The sensor module 215 including the light sensor may detect the amount of light using an illuminance sensing element. The sensor module 215 including the light sensor may be used when an insect robot that goes around searching for dark places is made.

The sound block 220 may include a PLC module 221, a control module 223, and a sound module 225. The sound module 225 may be implemented with a sound module that detects sound at the inner side of the housing 10 and changes the volume of the sound into an analog value.

For example, the sound module 225 may be used to make an electronic building block robot that moves forward when clapped once and moves backward when clapped twice. That is, an electronic assembly block robot that detects the clap sound may be made using the sound module 225.

The filming block 230 may include a PLC module 231, a control module 233, and a filming module 235. The filming block 230 may further include a wireless communication module (not shown). The filming module 235 may be implemented with a camera filming images. The filming block 230 may transmit the filmed image to a smart terminal using wireless communication.

The switch block 240 may include a PLC module 241, a control module 243, and a switch module 245.

The switch module 245 may be able to receive a state of being pressed-unpressed input thereto by being provided on an outer side of the housing 10. Accordingly, the switch module 245 may be electrically connected to the circuit board to perform a switch operation. For example, the switch module 245 may be implemented with a color button such as a red button or a green button provided on the switch block 240. The switch block 240 may be used when building an electronic assembly block robot, in which the red light of the light-emitting block 320 is turned on when the red button is pressed, and the red light of the light-emitting block 320 is turned off when the green button is pressed.

The output block 300 may include a driving block 310, a light-emitting block 320, and a melody block 330. The output blocks 310, 320, and 330, respectively, include PLC modules 311, 321, and 331 and control modules 313, 323, and 333, and a description thereof is the same as that of FIG. 7 and thus omitted. The output block 300 may output data according to a request signal received from the control block.

The driving block 310 may include a PLC module 311, a control module 313, and a driving module 315. The driving module 315 may be implemented with a motor and may perform an operation of moving the electronic assembly block.

The light-emitting block 320 may include a PLC module 321, a control module 323, and a light-emitting module 325. The light-emitting module 325 may be implemented with an LED element and may perform an operation of outputting light of various colors through LED elements of various colors.

The melody block 330 may include a PLC module 331, a control module 333, and a melody module 335. The melody module 335 may be implemented with a speaker and may perform an operation of outputting music in a form of sound in which a change in pitch of the sound is connected to a rhythm to provide a single musical integration.

Accordingly, the electronic assembly blocks may be used along with assembly blocks such as the existing Lego blocks and, by being connected to communicate with each other through control blocks and input/output blocks, may be used for building a toy robot model with flexible user-toy interaction and for helping to improve creativity along with fun in children.

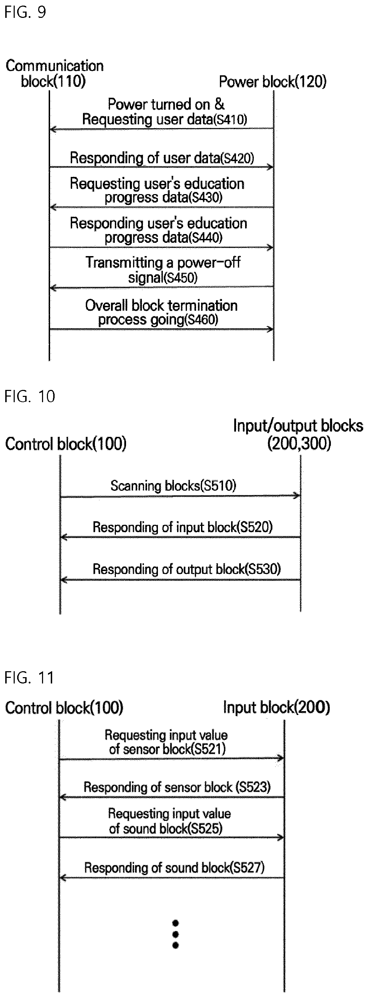

FIG. 9 is a flowchart explaining a data initialization process between a communication block and a power block of a control block according to the embodiment of the present disclosure.

With reference to FIG. 9, data flow in the communication block 110 and the power block 120 for a data initialization process between blocks of the control block 100 will be described. When a power switch of the power block 120 is turned on, the communication block 110 may read various types of initialization data such as user information and education progress information from the power block 120 which also functions as main memory.

Accordingly, when power is turned on to the power block 120 in S410, the communication block 110 requests user data in S420.

When the user data request is received from the communication block 110, the power block 120 responds with prestored user data in S430.

Thereafter, the communication block 110 requests the user's education progress data in S440.

When the user's request for the education progress data is received from the communication block 110, the power block 120 transmits the user's education progress data in response to the request in S450.

When the data initialization process is completed, the power block 120 may transmit a power-off signal in S460.

The power block 120 may transmit a response signal as shown in Table 1.

**[Table 1]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x90 | | 0x90 | | |

### <Response signal of power block 120>

Here, a DATA code responds with 0xFF in case of off mode and with 0x00 in case of on mode. Accordingly, the communication block 110 proceeds with an end process of initializing data for all electronic assembly blocks in S470.

The communication block 110 may transmit a data modification request signal for the electronic assembly block as shown in Table 2. Here, as information requiring data modification, the firmware version information is modified when the firmware of the electronic assembly block is upgraded, and user's educational progress information when the information is used as educational teaching material and name information of the electronic assembly block robot when the user's electronic assembly block robot is assigned to a name may be stored to be modified. In addition, as fixed information not modifying data, a product type, a country, a production date, and the like may be included.

**[Table 2]**

| STX | SIZE | KIND | ID | CMD | DATA (~66byte) | | | CS |
|---|---|---|---|---|---|---|---|---|
| | | | | | ADDH | ADDL | EEPROM DATA | |
| 1byte | 1byte | 1byte | 1byte | 1byte | 1byte | 1byte | ~64byte | 1byte |
| 0x02 | 0x05 | 0x01 | | 0x01 | dat[0] | dat[1] | dat[2] | |

### <Data modification request signal for electronic assembly block of communication block 110>

Here, STX means a start byte, SIZE means the number of bytes from SIZE to the front of CS, KIND means a type of electronic assembly block, ID means an identification number of the electronic assembly block, CMD means a command code, ADDH means an upper address (0x37), ADDL means a lower address (EEPROM area from 0x80 to 0x7F), and EEPROM DATA means data to be modified. CS means the checksum (that is, as a code for checking errors, the lower 1 byte of the value added from SIZE to the front of CS). Accordingly, the electronic assembly block may transmit a response signal as shown in <Table 3>.

**[Table 3]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | | | 0x01 | 0x55 | |

### <Response signal for data modification of electronic assembly block>

Meanwhile, when the checksum (CS) does not match, a response signal may be transmitted as shown in <Table 4>.

**[Table 4]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | | | 0x01 | 0xAA | |

### <Checksum mismatch response signal of electronic assembly block>

In addition, the communication block 110 may transmit a data reset request signal for the electronic assembly block as shown in <Table 5>. In the case of upgrading the firmware of an electronic assembly block, as an action of deleting data in memory, an erase operation may be performed first and then a write operation may be performed due to the nature of the memory.

**[Table 5]**

| STX | SIZE | KIND | ID | CMD | DATA (~66byte) | | | | CS |
|---|---|---|---|---|---|---|---|---|---|
| | | | | | ADDH | ADDL | LENH | LENL | |
| 1 byte | 1 byte | 1 byte | 1 byte | 1 byte | 1 byte | 1 byte | 1 byte | 1 byte | 1 byte |
| 0x02 | 0x 05 | | | 0x02 | Dat [0] | Dat [1] | Dat [2] | Dat [3] | |

### <Data reset request signal for the electronic assembly block of the communication block 110>

Here, STX means a start byte, SIZE means the number of bytes from SIZE to the front of CS, KIND means a type of electronic assembly block, ID means an identification number of the electronic assembly block, CMD means a command code, ADDH means an upper address, ADDL means a lower address (delete by page unit (0x40) of lower address, delete all pages including address), LENH means upper data length, and LENL means lower data length (Delete all pages including the data length). CS means the checksum (that is, the lower 1 byte of the value added from SIZE to the front of CS). Accordingly, the electronic assembly block may transmit a response signal as shown in <Table 6>.

**[Table 6]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | | | 0x02 | 0x55 | |

### <Response signal for data reset of electronic assembly block>

Meanwhile, when the checksum (CS) does not match, a response signal may be transmitted as shown in <Table 7>.

**[Table 7]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | | | 0x02 | 0xAA | |

### <Checksum mismatch response signal of electronic assembly block>

FIG. 10 is a flowchart explaining a process of checking a connection between a control block and input/output blocks according to the embodiment of the present disclosure. With reference to FIG. 10, the control block 100 may perform a block scan operation for checking whether the input/output blocks 200 and 300 are connected thereto.

Accordingly, the control block 100 performs the block scan operation for the input/output blocks 200 and 300 in S510.

Thereafter, each of the input/output blocks 200 and 300 may transmit a response signal according to the block scan operation.

That is, the input block connected to the control block 100 transmits a response signal in S520, and the output block connected to the control block 100 transmits a response signal in S530.

FIG. 11 is a flowchart explaining an operation between a control block and an input block according to the embodiment of the present disclosure.

With reference to FIG. 11, The control block 100 may periodically perform an operation of requesting an input value with respect to the connected input block 200.

The control block 100 may transmit a signal requesting input value with respect to the input block 200 as shown in <Table 8>.

**[Table 8]**

| STX | SIZE | KIND | ID | CMD | CS |
|---|---|---|---|---|---|
| 1byte | 1byte | 1byte | 1byte | 1byte | 1byte |
| 0x02 | 0x04 | | | Ox90 | |

### <Signal requesting input value with respect to the input block 200 of the control block 100>

Here, STX means a start byte, SIZE means the number of bytes from SIZE to the front of CS, KIND means a type of electronic assembly block, ID means an identification number of the electronic assembly block, CMD means a command code, and CS means the checksum (that is, the lower 1 byte of the value added from SIZE to the front of CS). Accordingly, the control block 100 requests an input value from the connected sensor block 210 in S521.

When receiving a request for an input value from the control block 100, the sensor block 210 transmits an input value in response thereto in S523.

The sensor block 210 may transmit response signals as shown in <Table 9> to <Table 13> according to the types of the sensor block 210.

**[Table 9]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x81 | | 0x90 | | |

### <Response signal of infrared sensor block>

Here, STX means a start byte, SIZE means the number of bytes from SIZE to the front of CS, KIND means a type of electronic assembly block, ID means an identification number of the electronic assembly block, DATA means a data code, and CS means the checksum (that is, the lower 1 byte of the value added from SIZE to the front of CS).

**[Table 10]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x83 | | 0x90 | | |

### <Response signal of light sensor block>

**[Table 11]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x85 | | 0x90 | | |

### <Response signal of ultrasonic sensor block>

**[Table 12]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x86 | | 0x90 | | |

### <Response signal of gyro sensor block>

**[Table 13]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x87 | | 0x90 | | |

### <Response signal of color sensor block>

To continue, the control block 100 may request an input value to the connected sound block 220 in S525.

When the input value request is received from the control block 100, the sound block 220 transmits the input value in response thereto in S527.

The sound block 220 may transmit a response signal as shown in <Table 14>.

**[Table 14]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x84 | | 0x90 | | |

### <Response signal of sound block>

As such, the control block 100 requests an input value from the connected input block 200, and the input block 200 that has received the input value request may transmit the input value in response to the request.

Additionally, the switch block 240 may transmit a response signal as shown in <Table 15>.

**[Table 15]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x82 | | 0x90 | | |

### <Response signal of switch block>

Meanwhile, when the checksum (CS) does not match, a response signal may be transmitted as shown in <Table 16>.

**[Table 16]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x86 | | 0x90 | 0xAA | |

### <Checksum mismatch response signal of electronic assembly block>

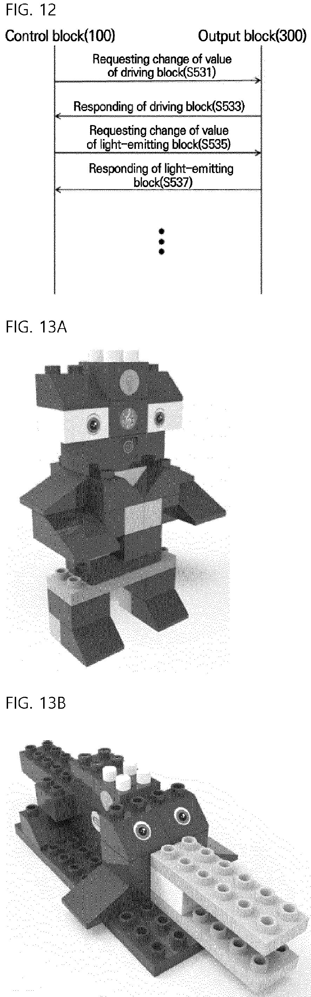

FIG. 12 is a flowchart explaining an operation between a control block and an output block according to the embodiment of the present disclosure.

With reference to FIG. 12, when the output value of the output block 300 needs to be changed, the control block 100 may perform an operation of requesting an output value.

Accordingly, the control block 100 requests the connected driving block 310 to change the output value in S531.

The control block 100 may transmit a request signal as shown in <Table 17> in order to set the motor speed of the driving block 310.

**[Table 17]**

| STX | SIZE | KIND | ID | CMD | DATA (~66byte) | CS |
|---|---|---|---|---|---|---|
| | | | | | SPEED | |
| 1byte | 1byte | 1byte | 1byte | 1byte | 1byte | 1byte |
| 0x02 | 0x05 | 0x01 | | 0xA0 | dat[0] | |

### <Output value change request signal of driving block 310>

Here, STX means a start byte, SIZE means the number of bytes from SIZE to the front of CS, KIND means a type of electronic assembly block, ID means an identification number of the electronic assembly block, CMD means a command code, and SPEED means a motor speed, and the motor speed may be set between -25 and 25. Here, when the speed value of the motor is 0, it means stop, when the speed value is 25, it means the maximum speed of forward rotation, and when the speed value is -25, it means the maximum speed of reverse rotation. However, when the speed value is out of the range of the input value, it may be forcibly corrected to 25 or -25. CS means the checksum (that is, the lower 1 byte of the value added from SIZE to the front of CS).

When receiving a request to change the output value from the control block 100, the driving block 310 changes the value in response and transmits a response signal in S533.

The driving block 310 may transmit a response signal as shown in <Table 18>.

**[Table 18]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x01 | | 0xA0 | 0x55 | |

### <Response signal of driving block 310>

Meanwhile, when the checksum (CS) does not match, a response signal may be transmitted as shown in <Table 19>.

**[Table 19]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x01 | | 0xA0 | 0xAA | |

### <Checksum mismatch response signal of driving block 310>

To continue, the control block 100 requests the connected light-emitting block 320 to change the output value in S535.

The control block 100 may transmit a request signal as shown in Table 20 in order to set the color of the light-emitting block 320.

**[Table 20]**

| STX | SIZE | KIND | ID | CMD | DATA (~66byte) | CS |
|---|---|---|---|---|---|---|
| | | | | | COLOR | |
| 1byte | 1byte | 1byte | 1byte | 1byte | 1byte | 1byte |
| 0x02 | 0x05 | 0x02 | | 0xB0 | dat[0] | |

### <Request signal to change the output value of the driving block 310>

Here, STX means a start byte, SIZE means the number of bytes from SIZE to the front of CS, KIND means a type of electronic assembly block, ID means an identification number of the electronic assembly block, CMD means a command code, COLOR means the emission color of the LED, and COLOR is 000 Black (0x00), 001 Red (0x01), 010 Green (0x02), 011 Blue (0x03), 100 Yellow (0x04), 101 Purple (0x05), 110 Cyan (0x06), and 111 White (0x07). CS means the checksum (that is, the lower 1 byte of the value added from SIZE to the front of CS). When a value change request is received from the control block 100, the light-emitting block 320 changes the value in response and transmits a response signal in S537.

The light-emitting block 320 may transmit a response signal as shown in <Table 21>.

**[Table 21]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x02 | | 0xB0 | 0x55 | |

### <Response signal of light-emitting block 320>

Meanwhile, when the checksum (CS) does not match, a response signal may be transmitted as shown in <Table 19>.

**[Table 22]**

| STX | SIZE | KIND | ID | CMD | DATA | CS |
|---|---|---|---|---|---|---|
| 1byte | 1byte | 1byte | 1byte | 1byte | 1byte | 1byte |
| 0x02 | 0x05 | 0x02 | | 0xB0 | 0xAA | |

### <Checksum mismatch response signal of light-emitting block 320>

As such, when the output value of the connected output block 300 needs to be changed, the control block 100 requests the connected output block 300 to change the output value, and the output block 300 which has received the request to change the output value may change the output value responding to the request and transmit a response signal.

FIGS. 13A and 13B are use state diagrams showing an embodiment of a toy robot model assembled with electronic assembly blocks according to the present disclosure.

With reference to FIG. 13A, this is an example of implementing a robot with a heart stone by assembling a number of the electronic assembly blocks and existing Lego blocks. As an electronic assembly block, it is assembled by stacking a melody block on top of a switch block and stacking a light-emitting block on top of the melody block. Although not shown in the drawing, the communication block and the power block are assembled together, and the remaining base may be assembled by stacking the existing Lego blocks to implement a robot having the heart stone.

At this time, the switch block, the melody block, and the light-emitting block are electrically connected through the connector, so that power and data may be transmitted and received through the power line communication. Thus, when the switch of the switch block is pressed, the melody flows through the melody block, and light-emitting may be made through the light-emitting block.

With reference to FIG. 13B, this is an example of implementing a crocodile model by assembling a number of the electronic assembly blocks and existing Lego blocks. As an electronic assembly block, a crocodile robot may be implemented by allowing a light-emitting block to be stacked on top of a power block and be assembled and the remaining base to be assembled by stacking the existing Lego blocks.

At this time, the power block and the light-emitting block are electrically connected through a connector, whereby power and data may be transmitted and received through the power line communication. Accordingly, power may be supplied to the power block and light-emitting may be made through the light-emitting block.

So far, the present disclosure has been looked at in detail, focusing on exemplary embodiments shown in the drawings. Such embodiments are merely illustrative rather than limiting to the present disclosure and should be considered from a descriptive point of view rather than a limiting point of view. The scope of the invention is defined by the appended claims.

## Claims

1. An electronic assembly block, the block comprising:
a first circuit board (30) provided with a first connector (20) disposed thereon, the first connector (20) including a cylindrical power data terminal (21) and a cylindrical ground terminal (23) disposed to be spaced apart from and at an outer side of the power data terminal (21);
a second circuit board (60) provided with a second connector (70) disposed thereon, the second connector having a cylindrical protrusion and including a power data piece (71) provided on an inner surface of the protrusion and a ground piece (73) provided on an outer surface of the protrusion;
a connection part electrically connecting the first circuit board (30) and the second circuit board (60);
a housing (10) having the first circuit board (30) and the second circuit board (60) disposed in a hollow thereof and providing an outer shell; and
a sub-housing (80) coupled with the housing (10) and having a through-hole provided at a part corresponding to the second connector (70) to allow the second connector to be exposed when coupled with the housing,
wherein, when at least two electronic assembly blocks are combined with each other, the cylindrical power data terminal (21) of the first connector (20) of a first block and the power data piece (71) provided on the inner surface of the protrusion of the second connector (70) of a second block are brought into contact with each other, and the cylindrical ground terminal (23) of the first connector (20) of the first block and the ground piece (73) provided on the outer surface of the protrusion of the second connector (70) of the second block are brought into contact with each other, so that the electronic building blocks combined with each other are electrically connected, the electronic building blocks being configured to supply power and to transmit and receive data by Power Line Communication (PLC) through the cylindrical power data terminal (21) of the first connector (20) of the first block and the power data piece (71) of the second connector (70) of the second block, and through the cylindrical ground terminal (23) of the first connector (20) of the first block and the ground piece (73) of the second connector (70) of the second block.

2. The block of claim 1, wherein the connection part comprises:
a connection socket (40) disposed on a surface opposite to a surface provided with a first connector (20) disposed thereon of the first circuit board and having one end configured to come in contact with an electrical contact and an opposite end provided with an opening configured to receive a pin; and
a connection pin (50) disposed on a surface opposite to a surface provided with a second connector (70) disposed thereon of the second circuit board and having one end configured to come in contact with an electrical contact and an opposite end provided with the pin configured to be correspondingly coupled with the opening.

3. The block of claim 1 or 2, further comprising:
a control block (100) configured to perform data communication by transmitting and receiving control signals to and from blocks assembled thereto;
an input block (200) configured to transmit an input signal detected from the outside to the control block; and
an output block (300) configured to output data according to a request signal received from the control block.

4. The block of claim 3, wherein the control block (100) is connected in series or parallel to the input block (200) and the output block (300) to perform data communication.

5. The block of claim 3 or 4, wherein the control block (100), the input block (200), and the output block (300) each comprise:
a PLC module (111) configured to supply or receive power and to transmit and receive data, through a PLC line; and
a control module (113) configured to transmit and receive a control signal with the PLC module.

6. The block of any of claims 3 to 5, wherein the control block (100) comprises:
a communication block (110) configured to wirelessly perform data communication with the blocks assembled thereto through a wireless communication module (115); and
a power block (120) configured to supply power to the blocks assembled thereto through a power storage unit.

7. The block of any of claims 3 to 6, wherein the input block (200) comprises at least any one of:
a sensor module (215) composed of a sensor configured to detect and operate at an inner side of the housing;
a sound module (225) composed of a sound sensor configured to detect sound at an inner side the housing and change volume of the sound into an analog value;
a filming module (235) composed of a camera configured to film an image; and
a switch module (245) provided with a switch configured to be able to receive a state of being pressed-unpressed input thereto by being provided on an outer side of the housing.

8. The block of claim 7, wherein the sensor module (215) comprises at least any one of a Gyro sensor, a Color sensor, an Infrared (IR) sensor, an Ultrasonic sensor, a Laser (distance) sensor, and a Light sensor.

9. The block of any of claims 3 to 8, wherein the output block (300) comprises at least any one of a driving block, a light-emitting block, and a melody block.

10. The block of any of claims 3 to 9, wherein the control block (100) is configured to perform a block scan operation for checking whether the input block and the output block are connected thereto.

11. The block of any of claims 3 to 10, wherein, when a power switch is turned on, the control block (100) is configured to perform an operation of reading initialization data from the power block to perform a data initialization process.

12. The block of any of claims 3 to 11, wherein, when an output value of the output block (300) needs to be changed, the control block (100) is configured to perform an operation of requesting the output block to change the output value.

## Patentansprüche

1. Elektronischer Baugruppenblock, wobei der Block Folgendes aufweist: eine erste Leiterplatte (30) mit einem ersten Verbinder (20) darauf angeordnet, wobei der erste Verbinder (20) einen zylindrischen Stromdatenanschluss (21) und einen zylindrischen Masseanschluss (23) hat, der so angeordnet ist, dass er vom Stromdatenanschluss (21) beabstandet und an einer Außenseite desselben liegt;
eine zweite Leiterplatte (60) mit einem zweiten Verbinder (70) darauf angeordnet, wobei der zweite Verbinder einen zylindrischen Vorsprung aufweist und ein Stromdatenteil (71), das an einer Innenfläche des Vorsprungs vorgesehen ist, und ein Masseteil (73), das an einer Außenfläche des Vorsprungs vorgesehen ist;
ein Verbindungselement, das die erste Leiterplatte (30) und die zweite Leiterplatte (60) elektrisch verbindet;
ein Gehäuse (10) mit einem Hohlraum, in dem die erste Leiterplatte (30) und die zweite Leiterplatte (60) angeordnet sind und das eine Außenhülle bildet; und
ein Untergehäuse (80), das mit dem Gehäuse (10) verbunden ist und ein Durchgangsloch an einem Teil aufweist, der dem zweiten Verbinder (70) entspricht, um zu erlauben, dass der zweite Verbinder freiliegt, wenn er mit dem Gehäuse gekoppelt ist,
wobei, wenn mindestens zwei elektronische Baugruppenblöcke miteinander kombiniert sind, der zylindrische Stromdatenanschluss (21) des ersten Verbinders (20) eines ersten Blocks und das Stromdatenteil (71), das an der Innenfläche des Vorsprungs des zweiten Steckverbinders (70) eines zweiten Blocks vorgesehen ist, miteinander in Kontakt gebracht werden, und der zylindrische Masseanschluss (23) des ersten Verbinders (20) des ersten Blocks und das Masseteil (73), das an der Außenfläche des Vorsprungs des zweiten Verbinders (70) des zweiten Blocks vorgesehen ist, in Kontakt miteinander gebracht werden, so dass die miteinander kombinierten elektronischen Baugruppenblöcke elektrisch miteinander verbunden sind, wobei die elektronischen Baugruppenblöcke konfiguriert sind, um mittels Power Line Communication (PLC) Leistung zu liefern und Daten zu übertragen und zu empfangen, und zwar über den zylindrischen Stromdatenanschluss (21) des ersten Verbinders (20) des ersten Blocks und das Stromdatenteil (71) des zweiten Verbinders (70) des zweiten Blocks und über den zylindrischen Masseanschluss (23) des ersten Steckverbinders (20) des ersten Blocks und das Masseteil (73) des zweiten Steckverbinders (70) des zweiten Blocks.

2. Der Block nach Anspruch 1, wobei das Verbindungselement folgendes aufweist:
eine Verbindungsbuchse (40), die auf einer Oberfläche gegenüber einer Oberfläche angeordnet ist, die mit einem ersten Verbinder (20) versehen ist, der darauf angeordnet ist, und die ein Ende aufweist, das so konfiguriert ist, dass es mit einem elektrischen Kontakt in Kontakt kommt, und ein gegenüberliegendes Ende, das mit einer Öffnung versehen ist, die so konfiguriert ist, dass sie einen Stift aufnehmen kann; und
einen Verbindungsstift (50), der auf einer Fläche gegenüber einer Fläche angeordnet ist, die mit einem darauf angeordneten zweiten Verbinder (70) der zweiten Leiterplatte versehen ist, und der ein Ende aufweist, das so konfiguriert ist, dass es mit einem elektrischen Kontakt in Kontakt kommt, und ein gegenüberliegendes Ende, das mit dem Stift versehen ist, der so konfiguriert ist, dass er entsprechend mit der Öffnung gekoppelt werden kann.

3. Der Block nach Anspruch 1 oder 2, der ferner Folgendes aufweist:
einen Steuerblock (100), der so konfiguriert ist, dass er Datenkommunikation durch Senden und Empfangen von Steuersignalen zu und von damit verbundenen Blöcken durchführt;
einen Eingangsblock (200), der so konfiguriert ist, dass er ein von außen detektiertes Eingangssignal an den Steuerblock sendet; und
einen Ausgangsblock (300), der so konfiguriert ist, dass er Daten entsprechend einem von dem Steuerblock empfangenen Anforderungssignal ausgibt.

4. Der Block nach Anspruch 3, wobei der Steuerblock (100) in Reihe oder parallel mit dem Eingangsblock (200) und dem Ausgangsblock (300) geschaltet ist, um Datenkommunikation durchzuführen.

5. Der Block nach Anspruch 3 oder 4, wobei der Steuerblock (100), der Eingangsblock (200) und der Ausgangsblock (300) jeweils Folgendes aufweisen:
ein PLC-Modul (111), das so konfiguriert ist, dass es über eine PLC-Leitung Strom liefert oder empfängt und Daten sendet und empfängt; und
ein Steuermodul (113), das so konfiguriert ist, dass es ein Steuersignal mit dem PLC-Modul sendet und empfängt.

6. Der Block aus einem der Ansprüche 3 bis 5, wobei der Steuerblock (100) Folgendes aufweist:
einen Kommunikationsblock (110), der so konfiguriert ist, dass er über ein drahtloses Kommunikationsmodul (115) drahtlos Daten mit den Blöcken austauscht, die mit ihm verbunden sind; und
einen Stromblock (120), der so konfiguriert ist, dass er die Blöcke, die mit ihm verbunden sind, über eine Stromspeichereinheit mit Strom versorgt.

7. Der Block nach einem der Ansprüche 3 bis 6, wobei der Eingangsblock (200) mindestens eines der folgenden Elemente aufweist:
ein Sensormodul (215), das aus einem Sensor aufgebaut ist, der so konfiguriert ist, dass er an einer Innenseite des Gehäuses detektiert und arbeitet; ein Schallmodul (225), das aus einem Schallsensor aufgebaut ist, der so konfiguriert ist, dass er Schall an einer Innenseite des Gehäuses detektiert und eine Veränderung der Lautstärke des Schalls in einen analogen Wert umwandelt;
ein Filmmodul (235), das aus einer Kamera aufgebaut ist, die so konfiguriert ist, dass sie ein Bild filmt; und
ein Schaltmodul (245), das mit einem Schalter ausgestattet ist, der so konfiguriert ist, dass er einen Zustand "gedrückt - nicht-gedrückt" empfangen kann, indem er an einer Außenseite des Gehäuses angebracht ist.

8. Der Block aus Anspruch 7, wobei das Sensormodul (215) mindestens einen der folgenden aufweist: einen Gyrosensor, einen Farbsensor, einen Infrarotsensor (IR-Sensor), einen Ultraschallsensor, einen Lasersensor (Entfernungssensor) und einen Lichtsensor.

9. Der Block nach einem der Ansprüche 3 bis 8, wobei der Ausgangsblock (300) mindestens einen Treiberblock, einen Lichtemissionsblock und einen Melodieblock aufweist.

10. Der Block nach einem der Ansprüche 3 bis 9, wobei der Steuerblock (100) so konfiguriert ist, dass er einen Block-Scan-Vorgang durchführt, um zu checken, ob die Eingangs- und Ausgangsblöcke mit ihm verbunden sind.

11. Der Block nach einem der Ansprüche 3 bis 10, wobei der Steuerblock (100) so konfiguriert ist, dass er beim Einschalten eines Netzschalters einen Vorgang zum Lesen von Initialisierungsdaten aus dem Leistungsblock durchführt, um einen Dateninitialisierungsprozess durchzuführen.

12. Der Block nach einem der Ansprüche 3 bis 11, wobei, wenn ein Ausgangswert des Ausgangsblocks (300) geändert werden muss, der Steuerblock (100) so konfiguriert ist, dass er einen Vorgang zum Auffordern des Ausgangsblocks zum Ändern des Ausgangswerts durchführt.

## Revendications

1. Bloc d'assemblage électronique, le bloc comprenant :
une première carte de circuit imprimé (30) sur laquelle est disposé un premier connecteur (20), le premier connecteur (20) comportant une borne de données d'alimentation cylindrique (21) et une borne de masse cylindrique (23) disposée de sorte à être espacée et sur un côté externe de la borne de données d'alimentation (21) ;
une deuxième carte de circuit imprimé (60) sur laquelle est disposé un deuxième connecteur (70), le deuxième connecteur ayant une saillie cylindrique et comportant un élément de données d'alimentation (71) prévu sur une surface interne de la saillie et un élément de masse (73) prévu sur une surface externe de la saillie ;
une partie de connexion connectant électriquement la première carte de circuit imprimé (30) et la deuxième carte de circuit imprimé (60) ;
un boîtier (10) dans un creux duquel sont disposées la première carte de circuit imprimé (30) et la deuxième carte de circuit imprimé (60) et qui assure une coque externe ; et
un sous-boîtier (80) relié au boîtier (10) et ayant un trou traversant prévu dans une partie correspondant au deuxième connecteur (70) pour permettre au deuxième connecteur d'être exposé lorsqu'il est relié au boîtier,
dans lequel, lorsqu'au moins deux blocs d'assemblage électroniques sont combinés l'un avec l'autre, la borne de données d'alimentation cylindrique (21) du premier connecteur (20) du premier bloc et l'élément de données d'alimentation (71) prévu sur la surface interne de la saillie du deuxième connecteur (70) d'un deuxième bloc sont amenés en contact l'un avec l'autre, et la borne de masse cylindrique (23) du premier connecteur (20) du premier bloc et l'élément de masse (73) prévue sur la surface externe de la saillie du deuxième connecteur (70) sont amenées en contact l'une avec l'autre, de sorte que les blocs d'assemblage électroniques combinés l'un avec l'autre soient connectés électriquement, les blocs d'assemblage électroniques étant configuré pour fournir de l'énergie et pour transmettre et recevoir des données par une communication de ligne d'alimentation (PLC) au moyen de la borne de données d'alimentation cylindrique (21) du premier connecteur (20) du premier bloc et l'élément de données d'alimentation (71) du deuxième connecteur (70) du deuxième bloc et au moyen de la borne de masse cylindrique (23) du premier connecteur (20) du premier bloc et l'élément de masse (73) du deuxième connecteur (70) du deuxième bloc.

2. Bloc selon la revendication 1, dans lequel la partie de connexion comprend :
une prise de connexion (40) disposée sur une surface opposée à une surface sur laquelle est disposé un premier connecteur (20) de la première carte de circuit imprimé et ayant une extrémité configurée pour entrer en contact avec un contact électrique et une extrémité opposée munie d'une ouverture configurée pour recevoir une broche ; et
une broche de connexion (50) disposée sur une surface opposée à une surface sur laquelle est disposé un deuxième connecteur (70) de la deuxième carte de circuit imprimé et ayant une extrémité configurée pour entrer en contact avec un contact électrique et une extrémité opposée munie de la broche configurée pour être reliée de façon correspondante à l'ouverture.

3. Bloc selon la revendication 1 ou 2, comprenant en outre :
un bloc de commande (100) configuré pour effectuer une communication de données en émettant et recevant des signaux de commande vers et depuis des blocs assemblés à celui-ci ;
un bloc d'entrée (200) configuré pour transmettre un signal d'entrée détecté de l'externe au bloc de commande ; et
un bloc de sortie (300) configuré pour fournir en sortie des données en fonction d'un signal de requête reçu en provenance du bloc de commande.

4. Bloc selon la revendication 3, dans lequel le bloc de commande (100) est connecté en série ou en parallèle au bloc d'entrée (200) et au bloc de sortie (300) pour effectuer une communication de données.

5. Bloc selon la revendication 3 ou 4, dans lequel le bloc de commande (100), le bloc d'entrée (200) et le bloc de sortie (300) comprennent chacun :
un module PLC (111) configuré pour fournir ou recevoir de l'énergie et pour transmettre et recevoir des données, au moyen d'une ligne PLC ; et
un module de commande (113) configuré pour transmettre et recevoir un signal de commande avec le module PLC.

6. Bloc selon l'une quelconque des revendications 3 à 5, dans lequel le bloc de commande (100) comprend :
un bloc de communication (110) configuré pour effectuer sans fil une communication de données avec les blocs assemblés à celui-ci au moyen d'un module de communication sans fil (115) ; et
un bloc d'alimentation (120) configuré pour fournir de l'énergie aux blocs assemblés à celui-ci au moyen d'une unité de stockage d'énergie.

7. Bloc selon l'une quelconque des revendications 3 à 6, dans lequel le bloc d'entrée (200) comprend au moins l'un quelconque parmi :
un module de capteur (215) constitué d'un capteur configuré pour détecter et fonctionner sur un côté interne du boîtier ;
un module sonore (225) constitué d'un capteur sonore configuré pour détecter le son sur un côté interne du boîtier et changer le volume du son en une valeur analogique ;
un module de prise de vue (235) constitué d'une caméra configurée pour filmer une image ; et
un module de commutation (245) muni d'un commutateur configuré pour pouvoir recevoir une entrée d'état enfoncé-non enfoncé en étant prévu sur un côté externe du boîtier.

8. Bloc selon la revendication 7, dans lequel le module de capteur (215) comprend au moins l'un quelconque parmi un capteur gyroscopique, un capteur de couleur, un capteur infrarouge (IR), un capteur à ultrasons, un capteur (de distance) laser et un capteur de lumière.

9. Bloc selon l'une quelconque des revendications 3 à 8, dans lequel le bloc de sortie (300) comprend au moins l'un quelconque parmi un bloc de pilotage, un bloc électroluminescent et un bloc de mélodie.

10. Bloc selon l'une quelconque des revendications 3 à 9, dans lequel le bloc de commande (100) est configuré pour effectuer une opération de balayage de bloc destinée à vérifier si le bloc d'entrée et le bloc de sortie lui sont connectés.

11. Bloc selon l'une quelconque des revendications 3 à 10, dans lequel, lorsqu'un interrupteur d'alimentation est passant, le bloc de commande (100) est configuré pour effectuer une opération de lecture de données d'initialisation à partir du bloc d'alimentation pour effectuer un processus d'initialisation de données.

12. Bloc selon l'une quelconque des revendications 3 à 11, dans lequel, lorsqu'une valeur de sortie du bloc de sortie (300) doit être modifiée, le bloc de commande (100) est configuré pour effectuer une opération de requête au bloc de sortie pour qu'il modifie la valeur de sortie.
